# EUROPEAN PATENT APPLICATION

(11) **EP 0 524 025 A2**
(43) Date of publication of application: **20.01.1993**
(21) Application number: 92306605.4
(22) Date of filing: 17.07.1992
(51) Int. Cl.: H01L 29/86, H01L 21/18

(54) **High-value resistors and methods for making same**

(30) Priority: 18.07.1991 US 732417
(71) Applicant: SGS-THOMSON MICROELECTRONICS, INC., Carrollton Texas 75006 (US)
(72) Inventor: Miller, Robert O., Denton County, Texas 75056 (US)
(74) Representative: Palmer, Roger

(57) **Abstract**

A high value integrated circuit resistor and method for making it are disclosed. The resistor includes a layer comprising silicon on a substrate, a BF₂ dopant in said layer comprising silicon, and a donor impurity dopant in contact regions of said layer comprising silicon. In one preferred embodiment the layer comprising silicon is amorphous silicon and in another preferred embodiment it is polysilicon.

A method for making the resistor is presented in which a layer of amorphous silicon or polysilicon is provided into which BF₂ is implanted. The energy by which the BF₂ is implanted is selected to place a peak of implanted BF₂ concentration near the center of the thickness of the polysilicon film. Contacts to the resistor are formed by implanting a donor type dopant, such as arsenic, into contact areas of the layer, and finally films of undoped oxide and BPSG are formed over the resistor, and reflowed to form a planarized surface.

## Description

This invention related to improvements in semiconductor fabrication techniques, and more particularly to improvements in methods for making resistors for use in integrated circuits.

A number of techniques exist for making high-value diode type resistors. Such resistors have, for instance, a p doped body and an n+ doped V_{cc} contact area, and have typical resistances in a range greater than 100 gigohms. One type of commonly used resistor is formed of a thin (500Å - 1500Å) polysilicon film that is lightly doped with boron in the resistor body and heavily doped with arsenic in the contact regions. The high resistance is achieved in the sub-breakdown voltage range of the reverse-biased diode junction existing at the interface between the two regions. The general way to make such a resistor is to deposit polysilicon in an ordinary manner, to dope the contact regions with high doses of arsenic or phosphorus, and to lightly dope the resistor body with boron. This method has several problems, one of which is the effects on resistor values of subsequent processing steps. For instance, a large increase in resistance often occurs during post-metal passivation steps, in the range of four to five times the prepassivation resistance. This increase, which occurs mostly in plasma depositions steps in H₂ ambients, is generally attributed to rapid indiffusion and incorporation of monatomic hydrogen from the plasma, and the passivation by the hydrogen of polysilicon grain boundaries near the junction. This decreases the leakage of the reverse diode. While it may be seen as beneficial in some instances to effect this resistance increase without the need to adjust other parameters, there are logistical drawbacks, such as uncertainty in prepassivation functional testing, in other instances.

It does not appear possible to block the influx of hydrogen completely, but elaborate techniques exist by which such hydrogen influx can be controlled. One method which is used, for instance, to hold the hydrogenation to very low levels is to encapsulate the resistors with a nitride film deposited by low pressure chemical vapor deposition (LPCVD) techniques. The problem with this method, aside from restricting the final resistance to a relatively low value, is that the presence of this new film makes the necessary etching of vertical contact walls through the resulting composite insulating film difficult, since oxide wet etches are highly selective over nitride.

Moreover, techniques for preventing hydrogen in-diffusion limit the magnitude of resistance achievable for a given thickness of polysilicon. While technology for polysilicon deposition is standard and mature, it is often troublesome to aim for, and measure, film thicknesses on the order of 500Å that are needed to get resistors having resistances above 5 or 6TΩ (1 TΩ ≡ 1TΩ ≡ 1X10¹² ohms). Also, achieving thickness uniformity over topography is a problem. It thus becomes useful to have a technique that will result in resistors having resistances greater than about 5TΩ at easily measured film thicknesses, for example, in the range of 1000Å.

In light of the above, it is, therefore, an object of the invention to provide an improved method for the fabrication of high-value resistors.

It is another object of the invention to provide a method of the type described which enables the formation of resistors which have a reverse-biased diode at an interface between doped regions of opposite conductivity type.

It is another object of the invention to provide a method of the type described that reduces previously encountered problems in resistance increases that occur during post-metal passivation steps.

It is still another object of the invention to provide a method of the type described in which the need for encapsulating the resistors to reduce the influx of hydrogen into the resistor are reduced or eliminated.

In it is yet another object of the invention to provide an improved method for the fabrication of high-value polysilicon resistors.

It is still another object of the invention to provide an improved method for fabricating integrated circuit resistors having resistances in the 10 to 20TΩ range with relatively little increase in resistance during passivation.

These and other objects, features and advantages of the invention will become apparent to those skilled in the art from the following detailed description, when read in conjunction with the accompanying drawings and appended claims.

In accordance with a preferred embodiment of the invention, an integrated circuit resistor is presented. The resistor includes a layer comprising silicon on a substrate. The layer comprising silicon can be either polysilicon or amorphous silicon. The layer is doped with BF₂, and contact regions of the layer are doped with a donor impurity dopant, such as arsenic.

In accordance with another broad aspect of a preferred embodiment of the invention a method for making a resistor for use in integrated circuits, or the like, is presented in which a layer of amorphous silicon or polysilicon is provided into which BF₂ is implanted. The energy by which the BF₂ is implanted is selected to place a peak of implanted BF₂ concentration near the center of the thickness of the film.

Contacts to the resistor are formed by implanting a donor type dopant, such as arsenic, into contact areas of the film, and films of undoped oxide and BPSG are formed over the resistor, and reflowed to form a planarized surface.

The invention is illustrated in the accompanying drawing, in which:

Figures 1(a) - 1(f) are cross-sectional views of an integrated circuit device including a polysilicon resistor in various stages of its manufacture, in accordance with the method of a preferred embodiment of the invention.

And Figures 2(a) - 2(e) are cross-sectional views of an integrated circuit device including an amorphous silicon resistor in various stages of its manufacture, in accordance with a method of another preferred embodiment of the invention.

In the various figures of the drawing, the sizes and dimensions of the parts have been exaggerated or distorted for clarity of illustration and ease of description. Also, in the various figures, like reference numerals are used to denote like or similar parts.

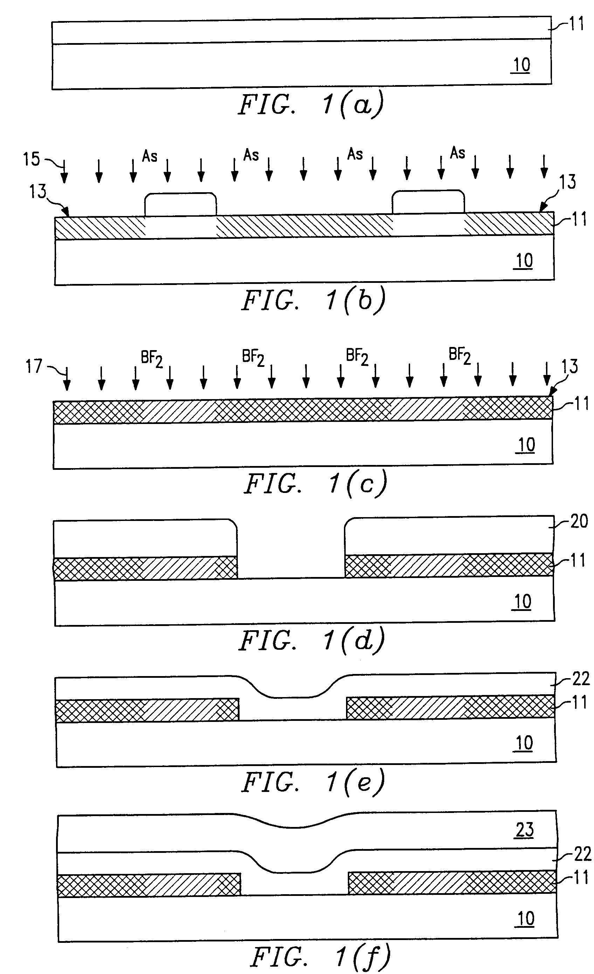

Thus, in accordance with one preferred embodiment of the invention, the steps for fabricating a resistor in a polysilicon layer are illustrated in Figures 1(a) - 1(f), cross-sectional views of an integrated circuit device in various stages of its manufacture. Such resistors can be used, for example, in many integrated circuit devices, one excellent example of use being 1 - 4 megabit, 4T2R SRAM devices. It should be noted that the process steps and structures herein described do not necessarily form a complete process flow for manufacturing integrated circuits. It is anticipated that the present invention may be practiced in conjunction with integrated circuit fabrication techniques currently used in the art, and only so much of the commonly practiced process steps are included as are necessary for an understanding of the present invention. Moreover, although the invention is illustrated with various parts and layers of certain conductivity types and of certain dopants of specified doping concentrations, those skilled in the art will recognize that other, perhaps even opposite, conductivity types, and other dopants and different doping concentrations might be used to equal advantage.

Thus, in accordance with one embodiment of the invention, BF₂ is implanted into a polysilicon resistor body. According to this embodiment, as shown in Figure 1(a), a layer 11 of polycrystalline silicon (polysilicon) is deposited onto a substrate 10 to a thickness of about 1000Å. (It should be noted that the term "substrate" is used herein in its broad meaning, and may denote any base material upon which processing steps are performed. Accordingly, the substrate may an insulating layer, or other suitable layer, as will be apparent to those skilled in the art. Also, the substrate as described and depicted in the drawings may not have neither the planar nor the stylized configurations shown; those forms being shown merely for purposes of illustration.) The deposition process can be by standard methods well-known in the industry. As shown in Figure 1(b), low resistance contact areas 13 of the polysilicon film 11 are patterned and implanted with a donor type dopant, such as arsenic 15, for example, with a dose of 2X10 ¹⁵ cm⁻² and an energy about 50 keV.

As shown in Figure 1(c), BF₂ 17 is implanted into the polysilicon film 11, for example, at a dose of between about 0.5X10¹² cm ⁻² and about 3X10 ¹² cm⁻², and more particularly, between about 1X10 ¹² cm⁻² and about 2X10 ¹⁵ cm⁻², and energy of about 55 keV. The implant energy is chosen to place the peak of the implanted dopant profile near the center of the thickness of the polysilicon film 11, and may vary depending upon the thickness of the polysilicon film 11. The implant energy can be determined by known techniques, such as by LSS computer modeling techniques or by other known process modeling simulation techniques to achieve the desired dopant concentration distribution.

As shown in Figure 1(d), the shape of the desired resistor structure, including contact areas, is patterned and etched, first by forming a layer of photoresist 20 over the doped polysilicon film 11, masking the regions desired to be removed, exposing unmasked regions of the photoresist layer to light or other radiation, and removing the unexposed portions of the mask and underlying polysilicon film 11, all as known in the art. The resistor body may be, for instance, 3.5 µm-long by 1.0 µm-wide. The remaining photoresist layer 20 is then stripped.

As shown in Figure 1(e) and 1(f), a film of undoped silicon oxide, SiO₂, 22, of thickness, for example of between about 1200Å and 2000Å, and a layer of boro-phoso-silicate glass (BPSG) 23 are formed over the resistor structure, and heated to reflow to planarize the surface. If desired, an anneal at about 875°C for about 25 minutes in N₂ can be performed between the steps of depositing the undoped oxide layer 22 and depositing the BPSG layer 23.

It should be noted that the order of the steps shown in Figures can be modified to nevertheless form the final structure shown in Figure 1(f). For example, the steps of Figures 1(b) and 1(c) can be performed in reversed order. Or, alternatively, the arsenic implant shown in Figure 1(b) can be performed after the selective removal of the polysilicon film 11 with appropriate masking, for instance, either by removal of the photoresist layer 20 and formation of a new, patterned photoresist mask, or by selective removal of the photoresist layer 20, followed by arsenic implant step, in the manner described above with regard to Figure 1(b).

It has been found that through the use of a BF₂ implant, the total increase in resistance during passivation can be held to less than 25%. This results in much more predictability of, and smaller spreads in, the final resistor values, as well as enabling more accurate functionality and performance testing of integrated circuit chips prior to passivation.

Moreover, the value of the resistance, both before and after passivation, is higher than that achieved by the corresponding steps of prior art processes in which boron is used in conjunction with nitride encapsulation described above. For example, in a typical boron implant process, a typical prepassivation resistance may be about 0.3 teraohms, and the postpassivation resistance may be about 0.9 teraohms, about 200% higher. On the other hand, according to the method of the present invention, it has been found that a prepassivation resistance of a 3.5 µm-long by 1.0 µm-wide resistor is about 0.376TΩ, and after passivation about 0.567TΩ, only about 24% higher. By way of comparison, in a boron implant process in which the resistor is encapsulated in a LPCVD nitride layer, a resistor may have a prepassivation resistance of about 0.20TΩ and a post-passivation resistance of about 0.25TΩ, a 25% increase, but only half the resistance achieved by the method of the invention. Consequently, it can be seen that the method of the present invention produces approximately the same improved post passivation increases, and double the resistance levels, as those previously produced by the LPCVD nitride encapsulation of a polysilicon resistor implanted in the conventional manner only with boron.

It should also be noted that the resistance of a polysilicon layer implanted in accordance with the method of the invention increases sharply as the thickness of the polysilicon layer is decreased. Thus, the final resistance of a layer of polysilicon having a thickness of about 500Å is about 4.2TΩ. It is believed that the resistance is related to the thickness of the polysilicon layer with an approximately t^{(-3.5)} dependency, where t stands for thickness. Thus, for example, final resistance of approximately 2.6TΩ at t = 600Å is expected, 4.2TΩ at t = 500Å, and 10TΩ at t = 400Å. However, as noted below, practical limitations on the magnitudes of resistance achievable exist. It is difficult to measure and realize uniform thickness of polysilicon films of thickness below about 800Å. Thus, a practical upper resistance limit for such polysilicon resistor is about 5TΩ.

Because BF₂ is a much heavier species than boron, it can be implanted directly into a polysilicon film with nearly all of it contained in the film, and with its distribution peak near the center of the thickness of the film. Boron, on the other hand, must be implanted through a screen oxide (or employing other special techniques) to center the peak when standard implant apparatuses are used, and, often, much of its profile is straggled outside of the polysilicon film.

Finally, since the BF₂ implantation in accordance with the method of the invention results in less hydrogenation of the polysilicon film of which the resistor is made, it is believed that the fluorine supplants hydrogen at the polysilicon grain boundaries. Since the dissociation energy of an Si-F bond is greater than that of an Si-H bond, the resistor of the invention would be more thermally stable than resistors previously produced.

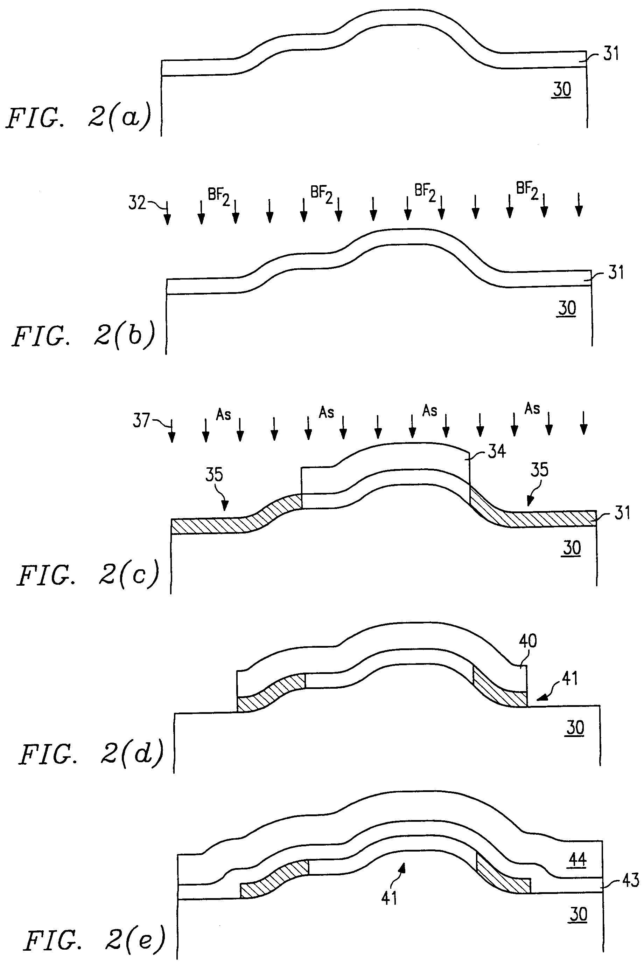

As mentioned, practical limitations on the magnitudes of resistance achievable in polysilicon resistors exist. Accordingly, according to another preferred embodiment of the invention, a method for fabricating high value resistors is illustrated in Figures 2(a) - 2(e), in which the resistors are formed in amorphous silicon to produce resistors which can have resistances in the 10 to 20TΩ range.

Thus, in accordance with this embodiment of the invention, BF₂ is implanted into an amorphous silicon film to form high value resistors. As shown in Figure 2(a), a layer of silicon, for example, of thickness of about 1000Å is deposited by LPCVD techniques at a temperature of about 560°C onto a substrate 30. This results in the production of an amorphous, rather than polycrystalline, silicon film 31.

Next, as shown in Figure 2(b), BF₂ 32 is implanted into the amorphous silicon film 31, for example with a dose of between about 0.5X10 ¹² cm ⁻² and about 3X10 ¹² cm⁻², and more particularly, between about 1X10¹² cm⁻² and about 2X10 ¹⁵ cm⁻², and at an energy about 55 keV. As before, an implant energy is selected for the BF₂ to place a peak of implanted BF₂ concentration near the center of the thickness of the amorphous silicon layer.

At this point, as shown in Figure 2(c), a first layer of photoresist 34 is formed and patterned on the amorphous silicon film 31 to define the areas 35 of the amorphous silicon film 31 which ultimately will be the low resistance contact areas for the high value resistor to be formed. The contact areas 35 of the amorphous silicon film 31 are then implanted with a donor dopant, such as arsenic 37, for example, with a dose of about 2X10¹⁵ cm⁻² and an energy of about 50 keV. The first layer 34 of photoresist is then stripped.

Next, as shown in Figure 2(d), the resistor structure itself, including its contact areas, is patterned. Again, the resistor body may be, for instance, 3.5 µm-long by 1.0 µm-wide. A second layer of photoresist 40 is formed and etched, leaving the desired resistor structure 41. The photoresist layer 40 is then stripped.

Finally, as shown in Figure 2(e), a film 43 of undoped silicon oxide, SiO₂, of thickness, for example of between about 1200Å and 2000Å, and a layer 44 of boro-phoso-silicate glass (BPSG) are formed over the resistor structure 41, and heated to reflow to planarize the surface. If desired, an anneal at about 875°C for about 25 minutes in an atmosphere containing N₂ can be performed between the steps of depositing the undoped oxide layer 43 and depositing the BPSG layer 44.

Again, it is noted that the order of the steps in the formation of the high value resistor can be altered while still achieving suitable devices. For example, the masking and implant of arsenic can precede the BF₂ implant without affecting the structure of the final devices. Similarly, the step of implanting the BF₂ can be performed after the patterning and etching of the resistor structure (shown in Figure 2(d)), while still achieving final devices of the same structure.

One of the principal benefits of the amorphous silicon embodiment of the present invention is that a 10 to 20TΩ resistor can be made without hydrogenation using a film whose thickness would, otherwise, limit resistor values to less than 1TΩ. For example, using the process described above, a 3.5 µm-long, 1.0 µm-wide, and 1000Å thick amorphous silicon resistor was made which had a resistance of 10TΩs before passivation, and 16TΩs after passivation, a 60% increase. In contrast, if boron alone were to be implanted into polysilicon, a thinner film, for example on the order of 600Å, would be required, and 20TΩ is the result of a 5-times increase over the prepassivation resistance.

Although the invention has been described and illustrated with a certain degree of particularity, it is understood that the present disclosure has been made only by way of example, and that numerous changes in the combination and arrangement of parts can be resorted to by those skilled in the art without departing from the spirit and scope of the invention, as hereinafter claimed.

## Claims

1. An integrated circuit resistor, comprising:
a substrate;
a layer comprising silicon on said substrate;
BF₂ dopant in said layer comprising silicon;
a donor impurity dopant in contact regions of said layer comprising silicon.

2. The integrated circuit resistor of claim 1 wherein said layer comprising silicon is polysilicon.

3. The integrated circuit resistor of claim 1 wherein said layer comprising silicon is amorphous silicon.

4. The integrated circuit resistor of any one of claims 1 to 3 further comprising a layer of undoped oxide overlying said layer comprising silicon and a layer of BPSG over said layer of undoped oxide.

5. The integrated circuit resistor of claim 1 or 4 wherein said donor impurity dopant is arsenic.

6. The integrated circuit resistor of claim 1 wherein said layer comprising silicon is about 1000Å thick, 3.5 µm-long and 1.0 µm-wide.

7. A method for making an integrated circuit resistor, comprising the steps of:
providing a layer comprising silicon on a substrate;
and implanting BF₂ into said layer comprising silicon.

8. The method of claim 7 wherein said step of providing a layer comprising silicon comprises the step of providing a layer of polysilicon.

9. The method of claim 7 wherein said step of providing a layer comprising silicon comprises the step of providing an amorphous silicon layer.

10. A method for forming an integrated circuit resistor, comprising the steps of:
forming a layer of amorphous silicon on a substrate;
implanting BF₂ into the layer amorphous silicon;
masking areas of said layer of amorphous silicon to define the low resistance contact areas for the high value resistor;
implanting a donor dopant into said low resistance contact areas;
patterning the amorphous silicon to define the resistor and low resistance contact areas;
forming a layer of undoped SiO₂ over said resistor and low resistance contact areas;
forming a layer of BPSG over said layer of SiO₂;
and reflowing said layers of undoped SiO₂ and BPSG to planarize the surface of the resulting structure.

11. The method of claim 7 or 10 wherein said step of forming a layer of amorphous silicon comprises depositing silicon by LPCVD techniques on said substrate to a thickness of about 1000Å at a temperature of about 560°C.

12. The method of claim 10 wherein said step of implanting a donor dopant into said low resistance contact areas comprises implanting said low resistance contact areas with arsenic with a dose of about 2X10¹⁵ cm⁻² and an energy of about 50 keV.

13. A method for making a polysilicon resistor, comprising the steps of:
providing a polysilicon layer;
and implanting BF₂ into said polysilicon layer.

14. A method for making a resistor, comprising the steps of:
providing a silicon layer comprising polysilicon on a substrate;
implanting BF₂ into said polysilicon layer;
implanting low resistance contact areas in said polysilicon layer;
patterning and etching said polysilicon layer to form a desired resistor structure shape;
forming a film of undoped oxide over said polysilicon layer and said substrate;
forming a layer of boro-phoso-silicate glass (BPSG) over said undoped oxide film;
and heating the structure to planarize the undoped oxide film and said BPSG layer.

15. The method of any one of claims 7, 8, 9, 10, 13 or 14 wherein said step of implanting said silicon with BF₂ comprises selecting an implant energy for said BF₂ to place a peak of implanted BF₂ concentration near the center of the thickness of said silicon layer.

16. The method of any one of claims 13, 14 or 15 wherein said silicon layer is provided with a thickness of about 1000Å.

17. The method of claim 15 to 16 wherein said step of implanting BF₂ comprises implanting BF₂ into said silicon layer with a dose of about 2X10¹⁵ cm⁻² and energy of about 55 keV.

18. The method of claim 7, 8, 9, 13 or 14 wherein low resistance contact areas are implanted in said silicon layer with a donor type dopant.

19. The method of claim 18 wherein said areas are implanted with a donar type dopant by implanting said areas with arsenic with a dose of 2X10¹⁵ cm⁻² and an energy about 50 keV.

20. The method of claim 10 or 14 further comprising annealing said undoped oxide before said layer of BPSG is formed.

21. The method of claim 20 wherein said step of annealing said undoped oxide comprises annealing said undoped oxide at a temperature of about 875°C for about 25 minutes in an atmosphere comprising N₂.
